# EUROPEAN PATENT APPLICATION

(11) **EP 4 496 016 A1**
(43) Date of publication of application: **22.01.2025**
(21) Application number: 23770485.3
(22) Date of filing: 03.03.2023
(51) Int. Cl.: H01L 33/58, F21S 41/148, F21V 9/20, F21V 9/30, G02B 5/20, H01L 33/00, H01L 33/50

(54) **SEMICONDUCTOR LIGHT-EMITTING DEVICE AND VEHICLE LAMP PROVIDED WITH SAME**

(30) Priority: 14.03.2022 JP 2022039502
(71) Applicant: Stanley Electric Co. Ltd., Tokyo 153-8636 (JP)
(72) Inventor: NIHEI, Noriko, Tokyo 153-8636 (JP); YAMAJI, Tomoaki, Tokyo 153-8636 (JP)
(74) Representative: Pritzlaff, Stefanie Lydia
(86) International application number: PCT/JP2023/008165
(87) International publication number: WO 2023/176528

(57) **Abstract**

Provided is a light-emitting device in which a change in chromaticity due to a change in an emission angle of a light-emitting element combining an LED element and a wavelength conversion part is suppressed and uniformity in chromaticity is improved. An optical multilayer film disposed on the light-emitting element has a transmission spectrum in which, when an angle in a direction perpendicular to a light-emitting surface is 0 degrees and an angle in a direction parallel to the light-emitting surface is 90 degrees, a transmittance increases monotonically in a range of 0 degrees to at least 60 degrees at a peak wavelength of the LED element, a transmittance increases monotonically in a range of 0 degrees to at least 60 degrees at a long wavelength region (650 nm to 700 nm), and a transmittance at 550 nm is 90% or more.

## Description

### Technical Field

The present invention relates to a semiconductor light-emitting device using a light-emitting diode (LED), and more particularly to a semiconductor light-emitting device that combines an LED with a wavelength conversion material to emit white light.

### Background Art

A semiconductor light-emitting device configured to emit white light by combining an LED with a wavelength conversion material usually has a structure in which a plate made of a wavelength conversion material or a layer containing a wavelength conversion material is superimposed on a flat light-emitting surface of an LED. In the light-emitting device with this structure, a phenomenon occurs in which the chromaticity of light changes as an emission angle becomes wider due to a difference in an optical path length from the light-emitting surface of the LED to the light-emitting surface of the light-emitting device, that is, a difference in the optical path length when passing through the wavelength conversion material. The change in chromaticity is such that a blue light is strong near an emission angle of 0 degrees, and as the emission angle becomes wider, light changes to a yellowish color, and a difference in chromaticity becomes larger.

For this change in chromaticity, it is possible to suppress the yellowish tint by forming an optical multilayer film on a wavelength conversion part and using wavelength-selective reflection of light by the optical multilayer film. For example, PTL 1 proposes that a filter layer constituted by an optical multilayer film is provided to partially reflect light (blue light) in a wavelength range of approximately 400 nm to 500 nm emitted from an LED in the range of an emission angle (radiation angle) of 0 to 30 degrees, thereby controlling the transmittance of the blue light and suppressing a yellow ring occurring on a wide-angle side by making a ratio between blue light and yellow light uniform in the range of a wide radiation angle.

### Citation List

### Patent Literature

PTL 1: JP5558483B

### Summary of Invention

### Technical Problem

However, in the related art such as PTL 1, as shown in Fig. 21, since only the transmittance of blue wavelengths in the vicinity of an emission angle of 0 degrees is controlled, a phenomenon occurs in which the wavelength shifts to a short wavelength side as the emission angle becomes wider (blue shift), and thus the transmittance of a blue wavelength band is significantly increased, making it impossible to control blue light. In addition, it is not possible to control the transmittance of yellow light which becomes stronger as the emission angle becomes wider, and thus a variation in chromaticity cannot be sufficiently suppressed.

An object of the present invention is to provide a light-emitting device in which a change in chromaticity caused by a change in an emission angle is suppressed and the uniformity of chromaticity is improved.

### Solution to Problem

The present invention solves problems of increased yellowness and a blue shift by controlling a transmittance not only in a blue wavelength region of a transmission spectrum of a multilayer film but also on a long wavelength side in a structure in which an optical multilayer film is disposed.

That is, a semiconductor light-emitting device of the present invention includes a light-emitting element that includes an LED element and a wavelength conversion part that receives light emitted by the LED element and emits light having a wavelength different from that of the light emitted by the LED element, the light-emitting element emitting light which is a mixture of the light emitted by the LED element and the light emitted by the wavelength conversion part, and an optical multilayer film that is disposed on a light-emitting surface of the light-emitting element. The optical multilayer film has a transmission spectrum in which, when an angle in a direction perpendicular to the light-emitting surface is 0 degrees and an angle in a direction parallel to the light-emitting surface is 90 degrees, a transmittance increases monotonically in a range of 0 degrees to at least 60 degrees at an emission peak wavelength of the LED element, a transmittance increases monotonically in a range of 0 degrees to at least 60 degrees at a long wavelength region (650 nm to 700 nm), and a transmittance at 550 nm is 90% or more.

The present invention also provides a vehicle lamp including the above-mentioned semiconductor light-emitting device.

### Advantageous Effects of Invention

According to the present invention, it is possible to suppress a change in chromaticity depending on an emission angle by controlling the transmittance in each of a blue wavelength region and a long wavelength region of an optical multilayer film disposed on a light-emitting element, and to obtain white light with high uniformity over a wide range of an emission angle.

### Brief Description of Drawings

[Fig. 1] Fig. 1 is a diagram showing a configuration of a semiconductor light-emitting device to which the present invention is applied.
[Fig. 2] Fig. 2 is a diagram showing a light emission spectrum of a light-emitting element when an optical multilayer film is not disposed.
[Fig. 3] Fig. 3 is a diagram showing a transmission spectrum of the optical multilayer film.
[Fig. 4] Figs. 4(A) and 4(B) are diagrams showing angle dependence of a variation in chromaticity.
[Fig. 5] Fig. 5 is a diagram showing the effect of suppressing a change in chromaticity by a multilayer film.
[Fig. 6] Figs. 6 (A) and 6(B) are diagrams showing a blue shift.
[Fig. 7] Fig. 7 (A) is a graph showing a relationship between an optical film thickness and a chromaticity value of a high refractive index layer at angles of 0 degrees and 60 degrees, and Fig. 7(B) is a graph showing a relationship between an optical film thickness and a variation in chromaticity of the high refractive index layer.
[Fig. 8] Fig. 8(A) is a graph showing a relationship between an optical film thickness and a chromaticity value of a low refractive index layer at angles of 0 degrees and 60 degrees, and Fig. 8(B) is a graph showing a relationship between an optical film thickness and a variation in chromaticity of the low refractive index layer.
[Fig. 9] Figs. 9(A) and 9(B) are diagrams showing an embodiment of the semiconductor light-emitting device of the present invention.
[Fig. 10] Fig. 10 is a diagram showing a transmission spectrum of an optical multilayer film according to Example 1.
[Fig. 11] Figs. 11(A) and 11(B) are diagrams showing a variation in chromaticity of the present invention and a variation in chromaticity of the related art.
[Fig. 12] Fig. 12 is a diagram showing changes in chromaticity according to Example 1.
[Fig. 13] Fig. 13 is a diagram showing a transmission spectrum of an optical multilayer film according to Example 2.
[Fig. 14] Fig. 14 is a graph showing angle dependence of a variation in chromaticity according to Example 2.
[Fig. 15] Fig. 15 is a graph showing changes in chromaticity according to Example 2.
[Fig. 16] Fig. 16 is a diagram showing a transmission spectrum of an optical multilayer film according to Comparative Example 1.
[Fig. 17] Fig. 17 is a graph showing changes in chromaticity according to Comparative Example 1.
[Fig. 18] Fig. 18 is a diagram showing a transmission spectrum of an optical multilayer film according to Comparative Example 2.
[Fig. 19] Fig. 19 is a graph showing changes in chromaticity according to Comparative Example 2.
[Fig. 20] Fig. 20 is a diagram showing an example of a vehicle lamp.

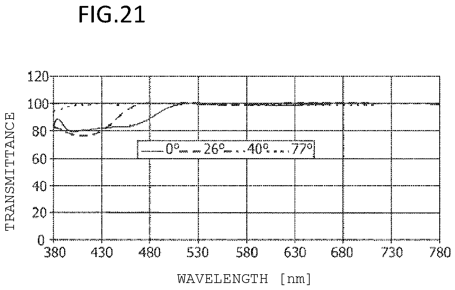

[Fig. 21] Fig. 21 is a diagram showing an example of a transmission spectrum of an optical multilayer film of the related art.

### Description of Embodiments

Hereinafter, an embodiment of a semiconductor light-emitting device of the present invention will be described.

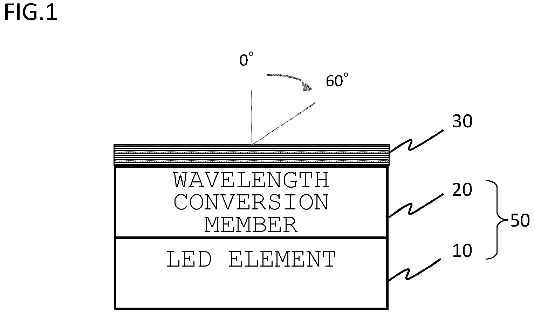

As shown in Fig. 1, the semiconductor light-emitting device of the present invention has a structure in which an LED (light-emitting diode) element 10, a wavelength conversion part 20, and an optical multilayer film (hereinafter simply referred to as a multilayer film) 30 are stacked in this order. Light emitted from the LED element 10 passes through the wavelength conversion part 20, a part of the light emitted from the LED element 10 is wavelength-converted by the wavelength conversion part 20, and light which is a mixture of the wavelength-converted light and the remaining part of the light emitted from the LED element 10 is incident on the multilayer film 30 and is emitted from the uppermost layer while being repeatedly reflected and transmitted within the multilayer film 30.

The multilayer film has transmittance characteristics that satisfy the following conditions for incident light, thereby improving the angle dependence of light emitted from the uppermost layer.

Condition 1: The transmittance of the LED element at an emission peak wavelength increases gradually (monotonically) from an incident angle of 0 degrees to at least 60 degrees. Preferably, in the same wavelength range, a transmittance at 0 degrees is 50% to 70%, and a transmittance at 60 degrees is 85% or less.

Condition 2: Conversely, a transmittance in a wavelength region of 650 nm to 700 nm decreases as an angle changes from 0 degrees to 60 degrees.

Condition 3: A transmittance at a wavelength of 550 nm is 90% or more in an angle range of 0 degrees to 60 degrees.

By satisfying these conditions 1 to 3, it is possible to suppress a phenomenon in which blue components are decreased at wide angles, an accompanying change in chromaticity to a yellow side, and a change in chromaticity from a white color, while maintaining a high transmittance in a wavelength region with high luminosity over a wide angle range. That is, chromaticity Cx and chromaticity Cy of light emitted from the light-emitting device in the CIE 1931 chromaticity system are both in the range of 0.30 to 0.40, and variations ΔCy and Δy in chromaticity of the emitted light in the CIE 1931 chromaticity system can both be suppressed to 0.03 or less.

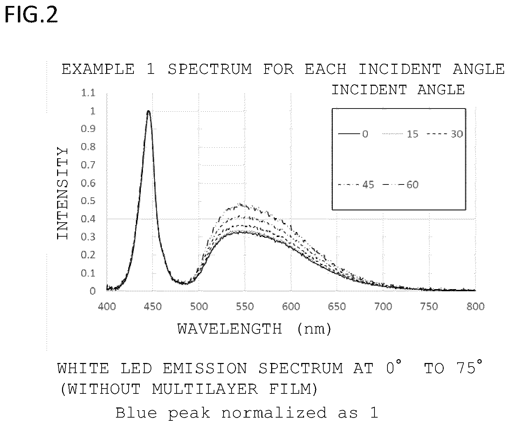

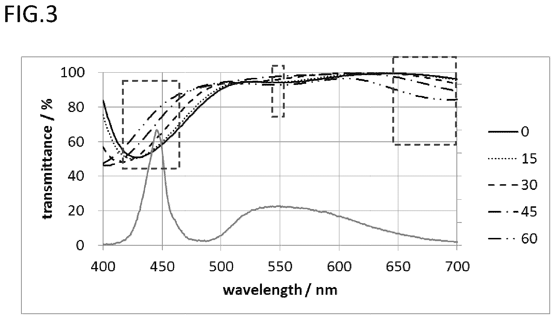

The above conditions 1 to 3 and the effects thereof will be described in detail below with reference to Figs. 2 and 3. Fig. 2 shows a light emission spectrum of a light-emitting element (LED + wavelength conversion layer) without a multilayer film, and Fig. 3 shows an example of a transmission spectrum of the multilayer film of the present invention. In Figs. 2 and 3, differences in an incident angle are represented by different line types, and Fig. 3 also shows a light emission spectrum for an angle of 0 degrees. In Fig. 2, a light emission spectrum for each incident angle is normalized with the peak of a blue light emission spectrum component which is set to 1.

As shown in Fig. 2, the light emission spectrum of the light-emitting element (LED + wavelength conversion layer) has a blue light emission spectrum component having a peak of which peak wavelength of approximately 445 nm, and a yellow light emission spectrum component having a peak of which peak wavelength of 540 nm to 570 nm and a broad peak spanned from 500 nm to 700 nm. In addition, the light emission spectrum without the multilayer film has a blue component decreasing as an angle becomes wider (due to a change in an optical path length). On the other hand, in the transmission spectrum of the multilayer film, as shown in Fig. 3, when the angle is changed from 0 degrees to 60 degrees, a transmittance is highest at 60 degrees and decreases monotonically to 0 degrees at approximately 445 nm, which is the emission peak wavelength of the LED, and the transmission spectrum changes gently. A transmittance at 0 degrees in this wavelength range satisfies 50% to 70%, and a transmittance at 60 degrees satisfies 85% or less (Condition 1).

In this manner, it is possible to suppress a decrease in blue components by increasing the transmittance in the blue region as the angle becomes wider. In addition, since the transmittance at 0 degrees to 60 degrees changes monotonically and gently, a blue shift (change in color) depending on an emission angle can also be suppressed. The suppression of the blue shift will be described later in detail.

As shown in Fig. 2, wavelength components at 500 nm to 700 nm of the light emission spectrum increase as an angle becomes wider, and such an increase in wavelength components appears as a change in chromaticity toward a yellow color. In addition, a red wavelength component at 650 nm to 700 nm in the wavelength components at 500 nm to 700 nm does not significantly change with respect to a blue wavelength component even as an angle becomes wider. On the other hand, the transmission spectrum of the optical multilayer film has a maximum transmittance at 0 degrees in the wavelength range of 650 nm to 700 nm and decreases monotonically as an angle becomes wider (Condition 2). According to Condition 2, it is possible to reduce the red wavelength components at 650 nm to 700 nm accompanying an increase in emission angle, suppress an increase in wavelength components at 500 nm to 700 nm, which acts synergistically with the control of the blue wavelength region (Condition 1) described above, thereby making it possible to suppress a change in chromaticity and maintaining the degree of whiteness.

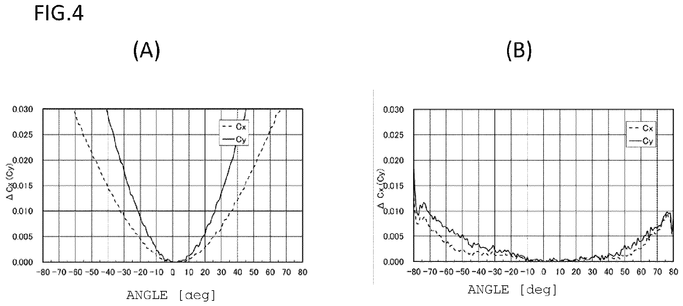

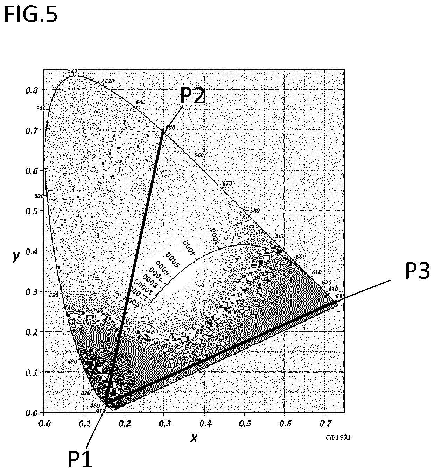

The change in chromaticity will be described with reference to Figs. 4 and 5. Fig. 4 shows a variation in chromaticity (Cy and variations in Cy) depending on an angle, and a left drawing (A) shows a state without a multilayer film, and a right drawing (B) shows a state with a multilayer film. As shown in the left drawing (A), when there is no multilayer film, both the chromaticity Cx and the chromaticity Cy change as an emission angle becomes wider from 0 degrees, and the change in a Cy value is particularly large. On the other hand, in the present invention, a change in chromaticity can be significantly suppressed as shown in the right drawing (B). Specifically, both the variations ΔCy and Δy in chromaticity in the CIE chromaticity coordinate system can be set to 0.03 or less.

Further, in a chromaticity diagram (CIE 1931 chromaticity coordinate system) shown in Fig. 5, when blue, green, and red colors are respectively indicated by P1, P2, and P3, Cx and Cy increase from a white color and chromaticity changes toward a yellow color as an angle becomes wider in a state where a multilayer film is not provided. However, an effect of increasing P1 components and shifting them to a lower left side in the drawing is obtained by Condition 1, an effect of reducing P3 components and shifting them to a left side in the drawing is obtained by Condition 2, and thus it is possible to suppress increases in Cx and Cy. A change in chromaticity toward a yellow color can be suppressed by suppressing the increase in Cy, and can be kept within a white color temperature region (near 0.33, for example, Cx and Cy in the range of 0.30 to 0.40) surrounded by a dashed line in the drawing.

Further, the multilayer film of the present invention has a transmittance of 90% or more at a wavelength of 550 nm, regardless of an emission angle (Condition 3). A transmittance in a wavelength region with high luminosity is set to be high over a wide emission angle range in this manner, and thus it is possible to maintain a high transmittance while maintaining the degree of whiteness.

That is, only a blue wavelength region is controlled in the related art, whereas the optical multilayer film of the present invention perform reverse control for gradually increasing a transmittance and gradually decreasing a transmittance as an angle becomes wider on both sides of a wavelength region of 650 nm to 700 nm, and maintains a high transmittance in a central wavelength region, thereby making it possible to suppress a blue shift occurring as an angle becomes wider to effectively suppress a phenomenon of light becoming yellowish while maintaining high emission efficiency for the light-emitting device as a whole.

Next, a configuration of a multilayer optical film that satisfies Conditions 1 to 3 described above will be described.

The optical multilayer film has a structure in which a plurality of optical layers with different refractive indices are stacked. A low refractive index layer is made of a material such as a transparent dielectric material with a refractive index of, for example, 1.6 or less, such as SiO₂ or MgF₂, and a high refractive index layer is made of a material with a refractive index of 1.6 or more, such as TiO₂, Al₂O₃, ZrO₂, HfO₂, Nb₂O₃, BaTi₂O₅, or Ta₂O₅.

The multilayer film has a structure in which a low refractive index material and a high refractive index material are alternately stacked, and a refractive index difference is preferably 0.6 to 1.0 (550 nm). A typical example of a combination for realizing such a refractive index difference is SiO₂/Nb₂O₅. When a low refractive index layer is disposed on the uppermost layer on a light emitting side, a structure in which a low refractive index layer is disposed as the lowermost layer and high refractive index layers and low refractive index layers are alternately disposed is preferable.

The number of layers in the optical multilayer film is nine or less, preferably seven or less, and most preferably five. In general, the number of layers is increased (for example, approximately 10 to 30) in a multilayer film combined with an LED to suppress "waviness" occurring in a transmission spectrum, but in the present invention, the number of layers is reduced compared to a general multilayer film, specifically, set to nine or less, and thus it is possible to suppress a shift of a transmission spectrum to a short wavelength side for each angle (so-called blue shift) and it becomes easier to adjust chromaticity.

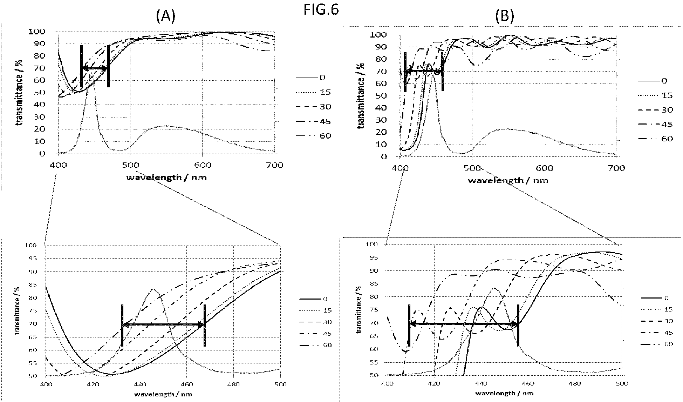

A blue shift is a phenomenon that occurs when an apparent film thickness changes as an angle of light becomes wider, and the degree of the blue shift increases as the number of layers increases and the film thickness increases. Suppression of a blue shift according to the present invention will be described with reference to Fig. 6.

Figs. 6(A) and 6(B) are diagrams showing examples of transmission spectra of multilayer films with different numbers of layers (lower diagrams are partially enlarged views), where Fig. 6(A) shows a transmission spectrum of a multilayer film with five layers, and Fig. 6(B) shows a transmission spectrum of a multilayer film with nine layers, which are made of the same layer forming materials as in Fig. 6(A). In each of these drawings, a blue shift at a 70% position at a transmittance rising wavelength is shown. A wavelength serving as the reference for the blue shift is a blue peak position in a pseudo-white spectrum (a spectrum of white light obtained by combining an LED and a wavelength conversion part), and is 420 nm to 460 nm, preferably 440 nm to 455 nm.

As shown in Fig. 6(B), in a transmission spectrum of a multilayer film having a relatively large number of layers, waviness occurs after the rising of the transmission spectrum, and a shift amount accompanying a change in an emission angle is large. However, in the transmission spectrum in Fig. 6(A), a rising part of the transmission spectrum has a gentle inclination, and a blue shift at a transmittance of 70% is significantly smaller than that of the transmission spectrum in Fig. 6(B) . That is, in the multilayer film having a large number of layers of the related art, the blue shift becomes large, and thus it is not possible to adjust chromaticity in a blue wavelength region at a wide angle. However, according to the present invention, it is possible to reduce a blue shift, and it becomes easier to adjust chromaticity along with Condition 1 described above.

For the thickness (optical film thickness) of a thin film constituting the optical multilayer film, an appropriate value can be obtained from correlation between a chromaticity value and the optical film thickness. The optical film thickness (FWOT) is a film thickness defined as nd/λ, where d is a physical film thickness and n is a refractive index of a film material. Here, λ is a central wavelength of a reflection wavelength band of the optical multilayer film. In addition, λ is selected from the range of 400 nm or more and a blue emission peak wavelength region or less (in this embodiment, approximately 475 nm or less, which is an end on a long wavelength side of a blue emission peak), preferably from the range of the blue emission peak wavelength or less (in this embodiment, approximately 445 nm or less, which is the blue emission peak wavelength).

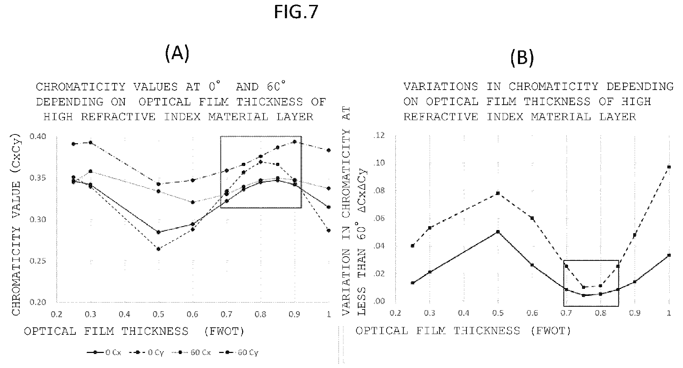

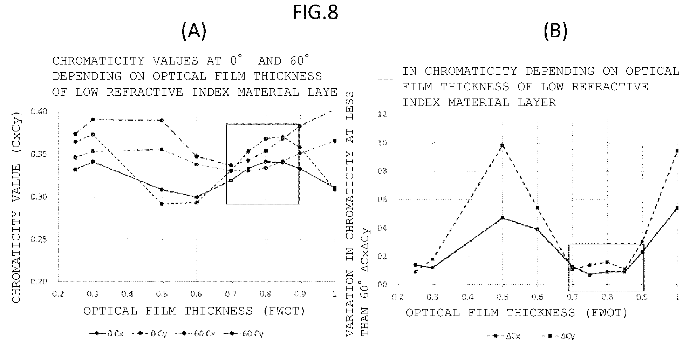

Fig. 7 shows a relationship (A) between each optical film thickness of a high refractive index layer and a chromaticity value (Cx, Cy) and a relationship (B) between each optical film thickness and a variation (ΔCx, ΔCy) in chromaticity, and Fig. 8 shows a relationship (A) between each optical film thickness of a low refractive index layer and a chromaticity value (Cx, Cy) and a relationship (B) between each optical film thickness and a variation (ΔCx, ΔCy) in chromaticity. In Fig. 7(A) and Fig. 8 (A), four graphs show Cx values and Cy values at angles of 0 degrees and 60 degrees, and two graphs in Fig. 7(B) and Fig. 8(B) show ΔCy and ΔCy. The illustrated example shows the case of a five-layer structure using Nb₂O₅ as a high refractive index material and using SiO₂ as a low refractive index material.

When the optical film thicknesses of the high refractive index layer and the low refractive index layer are changed to 0.25 to 1.0, the chromaticity value changes as shown in Fig. 7(A) and Fig. 8(A), and the variation in chromaticity changes as shown in Fig. 7(B) and Fig. 8(B). As described above, the chromaticity value of the light-emitting device of this embodiment is approximately 0.33 (the range of 0.30 to 0.40) where the chromaticity of each of Cx and Cy is white, and the variation (ΔCxCy) in chromaticity is preferably 0.03 or less. Thus, based on the graphs shown in Fig. 7 and Fig. 8, the optical film thicknesses of the high refractive index layer and the low refractive index layer can be determined within a range that satisfies a chromaticity value and a variation in chromaticity.

Specifically, in order to satisfy conditions of chromaticity, it has been derived that the optical film thickness of the high refractive index layer is preferably 0.70 to 0.85 FWOT, and the optical film thickness of the low refractive index layer is preferably 0.7 to 0.9 FWOT. However, the optical film thickness is determined based on correlation with a chromaticity value, and is not limited to the above range. When the material or layer structure is different, a suitable optical film thickness can be determined based on the above-described conditions of chromaticity and a variation in chromaticity.

The transmission spectrum and structural features of the optical multilayer film have been described above. Next, a configuration of a semiconductor light-emitting device including the above-described optical multilayer film and elements constituting the semiconductor light-emitting device will be described.

As shown in Fig. 1, the semiconductor light-emitting device has a basic structure in which the LED element 10, the wavelength conversion part 20, and the optical multilayer film 30 are stacked in this order. The LED element 10 and the wavelength conversion part 20 are collectively referred to as a light-emitting element 50.

The LED element 10 is an element that emits light mainly in a blue wavelength region. Known materials such as nitride-based semiconductors such as (Al, Ga, In)N can be used, and an emission wavelength varies depending on proportions of Al, Ga, and In in materials forming an active layer. In this embodiment, although not limited thereto, an LED having a peak in a blue band (for example, a range of 420 nm to 460 nm) of a light emission spectrum is used.

The wavelength conversion part 20 is constituted by a member that absorbs light emitted by the LED element 10 and emits light with a wavelength different from that of the light emitted by the LED element 10. Specifically, a wavelength conversion material containing phosphor particles that convert a part of blue light into yellow light and having light scattering properties can be used. As the wavelength conversion material, known phosphors such as a YAG-based phosphor represented by YAG (yttrium aluminum garnet, Y₃Al₅O₁₂) :Ce or a BOS-based phosphor represented by (Ba, Sr)₂SiO₄:Eu²⁺ can be used. As the form of the wavelength conversion part 20, a resin layer containing these phosphor particles, a transparent body containing light conversion nanoparticles, or the like can be adopted. In this embodiment, although not limited thereto, the wavelength conversion material is excited by the light emitted by the LED element 10 and emits light having a peak wavelength of 540 nm to 570 nm.

The wavelength conversion material converts the wavelength of a part of light incident on the wavelength conversion part 20 from the LED element 10, and transmits the remaining part. Thereby, the light emitted from the LED element 10 and the wavelength-converted light are mixed and emitted from the wavelength conversion material. White light emission can be obtained by appropriately combining the emission wavelength of the LED element 10 and the wavelength of the wavelength-converted light. In this embodiment, a blue LED element having a peak in the range of 420 nm to 460 nm is combined with a wavelength conversion material having a peak in the range of 540 nm to 570 nm, but other wavelength conversion materials can also be added.

The multilayer film 30 described above is disposed on the upper surface of the light-emitting element 50, which is a combination of the LED element 10 and the wavelength conversion part 20. A part of blue light emitted from the light-emitting element 50 is reflected by the multilayer film 30, and the larger an incident angle into the multilayer film, the higher the transmittance at emission angles of 0 to 60 degrees. In addition, the light reflected by the multilayer film is scattered after being incident on the wavelength conversion part and converted into blue light and newly yellow light. A part of the light is incident on the multilayer film again, but the blue light is configured to be emitted with a higher transmittance as the incident angle thereof becomes larger.

Due to such characteristics of the transmission spectrum of the optical multilayer film, the light-emitting device of the present invention can emit white light with a suppressed change in chromaticity depending on an emission angle.

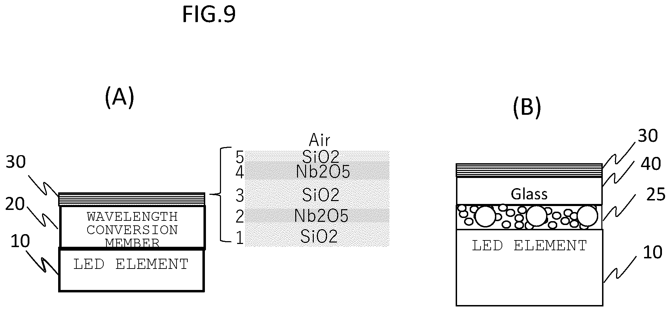

Next, a specific embodiment of a semiconductor light-emitting device will be described with reference to Figs. 9(A) and 9(B). A semiconductor light-emitting device according to a first embodiment shown in Fig. 9(A) includes an LED element 10 that emits blue light, a wavelength conversion part 20 disposed thereon, and an optical multilayer film 30 formed on the wavelength conversion part 20, and the uppermost surface of the optical multilayer film 30 is a light-emitting surface.

The wavelength conversion part 20 of this embodiment is, for example, a ceramic plate manufactured by firing alumina and a YAG phosphor at high temperature, and has a refractive index of 1.8. A multilayer film forming surface of the wavelength conversion part constituted by a ceramic plate is preferably subjected to flattening processing by polishing or the like. On the other hand, a surface of the wavelength conversion part, which is constituted by a ceramic plate, opposite to the multilayer film forming surface is preferably a sintered surface without being subjected to flattening processing. The wavelength conversion part 20 is mounted on the LED element 10 via an adhesive layer of such as a resin. It is also possible to use a single crystal phosphor instead of the ceramic plate as the wavelength conversion part 20.

The optical multilayer film 30 is formed by alternately stacking low refractive index layers and high refractive index layers directly on the wavelength conversion part (ceramic plate) 20 by a known film forming method such as electron beam sputtering. As shown on the right side in Fig. 9(A), the multilayer film has a structure in which, for example, a first layer in contact with the ceramic plate 20 and the uppermost layer are low refractive index layers and high refractive index layers are disposed between the low refractive index layers, the number of layers is an odd number. In the first embodiment shown in Fig. 9(A), the low refractive index layers are made of SiO₂ (n = 1.46), the high refractive index layers are made of Nb₂O₅ (n = 2.33), and the multilayer film having five layers is formed.

The uppermost layer is a layer that functions as an adjustment layer for extracting light, and is referred to here as an adjustment layer to distinguish it from the other low refractive index layers. A film thickness (physical film thickness) d of each layer excluding the adjustment layer is 100 nm to 150 nm for the low refractive index layer and 200 nm to 300 nm for the high refractive index layer, and an optical film thickness (FWOT = d*n/λ) taking a refractive index n and a wavelength λ of light into account is 0.7 to 0.9 at λ = 410. The physical film thickness of the uppermost layer is 100 nm or less, and the optical film thickness thereof is 0.4 or less.

As described above, both the low refractive index material and the high refractive index material are set to have approximately 0.75 FWOT, and thus it is possible to obtain characteristics with a suppressed variation in chromaticity depending on an angle.

A semiconductor light-emitting device according to a second embodiment shown in Fig. 9(B) includes an LED element 10 that emits blue light, a wavelength converting material-containing resin layer (= a wavelength conversion part 20, hereinafter referred to as a wavelength conversion layer 25) stacked thereon, a plate made of a transparent material such as glass (hereinafter referred to as a glass plate) 40, and an optical multilayer film 30, and the uppermost surface of the optical multilayer film 30 is a light-emitting surface.

The wavelength conversion layer 25 is manufactured by dispersing glass beads and YAG phosphor particles in a transparent resin such as a silicone resin and coating the surface of the LED 10. For example, the refractive index of the wavelength conversion layer used in this embodiment is 1.82.

The glass beads define the film thickness of the wavelength conversion layer 25. The film thickness is adjusted based on the conversion efficiency of the wavelength conversion layer 25 that absorbs light from the LED 10 and converts the wavelength of the light, and the like, and is not particularly limited, but is approximately 7 um to 40 um. The particle size of the phosphor particle is preferably 40 um or less, and more preferably 30 µmnm or less.

The glass plate 40 defines the shape of the surface (light emission side) of the wavelength conversion layer 25, and also functions as a substrate for the optical multilayer film 30. The thickness of the glass plate 40 is not limited, but is approximately 0.1 mm to 0.5 mm.

The optical multilayer film 30 is the same as the optical multilayer film in the first embodiment, except that it is formed on the glass plate 40.

The elements constituting the semiconductor light-emitting device of the present invention have been described above. However, for the purpose of mounting, the semiconductor light-emitting device may also include means such as lead wires for supplying power to the LED, members for supporting or holding the LED, the wavelength conversion part, and the optical multilayer film, known accessory components, and the like, and light-emitting devices including such members are also included in the present invention.

The semiconductor light-emitting device of the present invention can be applied to all applications, such as vehicle lamps such as headlamps, and lighting appliances, for which it is desired to eliminate yellowish color unevenness from the center to the outer side in light emitted from an LED.

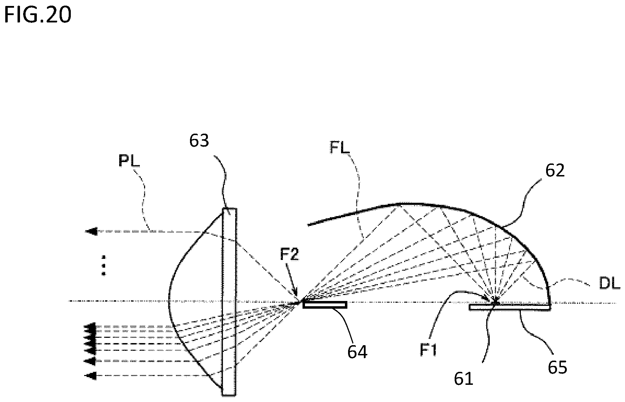

Fig. 20 is a schematic side view of a headlamp 60 as an example of a vehicle lamp. The headlamp 60 includes a semiconductor light-emitting device 61, a condensing reflector 62, a projection lens 63, and a shade 64. The semiconductor light-emitting device 61, which is the above-described semiconductor light-emitting device of the present invention, includes an LED, a wavelength conversion part, and an optical multilayer film and is mounted on a substrate 65. The semiconductor light-emitting device 61 radiates emitted light DL in a predetermined angle range. The condensing reflector 62 is, for example, an elliptical reflecting surface, and condenses the emitted light DL from the semiconductor light-emitting device 61 disposed at a first focal point F1 to generate condensed light FL to be condensed at a second focal point F2. The projection lens 63 projects the condensed light FL from the condensing reflector 62 to generate projection light PL. The shade 64 includes a mirror surface, is disposed near the second focal point F2, and blocks a part of the condensed light FL at a front edge on the projection lens 63 side.

The headlamp 60 configured as described above forms a light distribution pattern for passing-each-other (so-called low beam) having a cut-off line at an upper end thereof by inverting and projecting a light source image of the semiconductor light-emitting device 61 defined by the end of the shade 64 disposed at the second focal point F2 using the projection lens 63. With the vehicle lamp (here, the headlamp 60) of the present invention, it is possible to suppress color unevenness in a light source image and a light distribution pattern by adopting the semiconductor light-emitting device 61 of the present invention as a light-emitting element.

### Examples

### <Example 1>

In an LED package having the configuration shown in Fig. 9(A), a multilayer film having the following configuration was formed on a wavelength conversion part to manufacture a light-emitting device according to Example 1.

### [Table 1]

**Table 1**

| | Composition | Optical film thickness (FWOT: λ 410 nm) |
|---|---|---|
| 5th layer (uppermost layer) | SiO₂ | 0.287 |
| 4th layer | Nb₂O₅ | 0.775 |
| 3rd layer | SiO₂ | 0.871 |
| 2nd layer | Nb₂O₅ | 0.767 |
| 1st layer (lowermost layer) | SiO₂ | 0.725 |

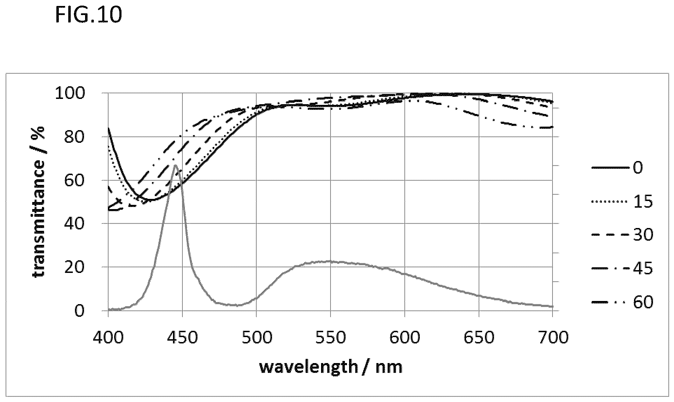

Fig. 10 shows a transmission spectrum of the multilayer film when an incident angle of light is changed in 15 degree increments. This transmission spectrum was obtained by using a difference between a light emission spectrum when the multilayer film was not formed and a light emission spectrum after the multilayer film was formed. From Fig. 10, it can be understood that the multilayer film in this example has a transmittance that satisfies 60% or more at an angle of 0 degree in a blue emission wavelength region (400 nm to 470 nm) and gradually increases as the angle increases, and a blue component that decreases as the angle becomes wider can be adjusted by the increase in transmittance. Further, it can be understood that a transmittance gradually decreases as an angle changes from 0 degrees to 60 degrees in a wavelength region of 600 nm or more, the chromaticity is adjusted accordingly.

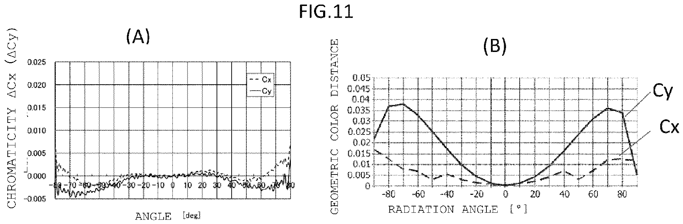

Fig. 11(A) is a diagram showing a variation (ΔCx, ΔCy) in chromaticity (Cx, Cy) depending on an angle which is measured for the light-emitting device after the multilayer film of Example 1 is stacked, and Fig. 11(B) shows changes in chromaticity of a conventional light-emitting device. In Fig. 11, the values of ΔCx and ΔCy are numerical values of variations in chromaticity for light within ±80 degrees.

As shown in Fig. 11(B), in the conventional light-emitting device, a change in Cx (dashed line) is relatively small, but the change in Cy value (solid line) depending on a radiation angle is large, and the chromaticity is not sufficiently controlled. On the other hand, in a graph (A) of Example 1, a change in chromaticity depending on an angle is suppressed for both Cx and Cy, and it can be understood that a uniform chromaticity is achieved without depending on the angle.

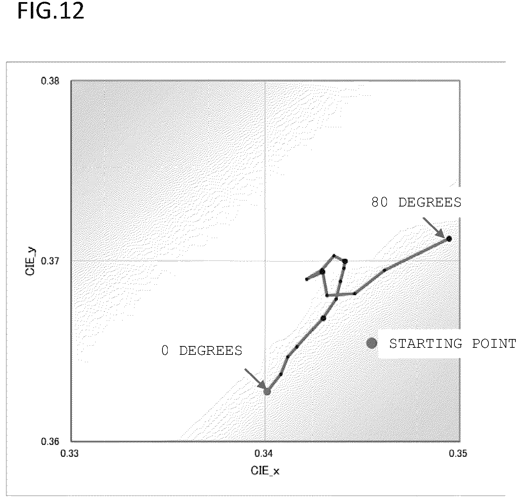

In addition, Fig. 12 shows changes in chromaticity depending on the angle of the light-emitting device of Example 1. Fig. 12 is a graph showing changes in chromaticity at intervals of 5 degrees when an emission angle is changed from 0 degrees to 80 degrees on a chromaticity diagram. A lower left part of a broken line indicates an emission angle of 0 degrees, an upper right part indicates an incident angle of 80 degrees, and plots are connected by lines at intervals of 5 degrees. Cx and Cy increase at an incident angle of 0 degrees to 40 degrees, at least one of Cx and Cy decreases from 40 degrees to 65 degrees, and Cx and Cy increase again from 65 degrees to 80 degrees. A difference between a Cx value and a Cy value was maximum at an emission angle of 0 degrees and an emission angle of 80 degrees. A difference in Cx value between an emission angle of 0 degrees and an emission angle of 80 degrees was 0.004, and a difference in Cy value was 0.008. That is, in a wide range from an emission angle of 0 degrees to an emission angle of 80 degrees, both the difference in Cx value and the difference in Cy value could be suppressed to 0.01 or less. In the graph, a large chromaticity coordinate distance between the emission angle of 0 degrees and the emission angle of 80 degrees means a large change, but if the broken line in the graph has a chromaticity turning point, more preferably, the broken line in the graph has a rotating part, it means that a change in a chromaticity value depending on an emission angle is effectively suppressed. The graph shown in Fig. 12 is a graph with a rotating part of the broken line, and it can be understood that a change in chromaticity is small in Example 1.

Further, the transmission spectrum (Fig. 10) in Example 1 maintains a transmittance spectrum of 90% or more at 550 nm, and thus it can be understood that luminosity is high and brightness is maintained.

### <Example 2>

In an LED package having the configuration shown in Fig. 9(B), a multilayer film having the following configuration was formed on a glass plate 40 on a wavelength conversion layer 25 to manufacture a light-emitting device according to Example 2.

### [Table 2]

**Table 2**

| | Composition | Optical film thickness (FWOT: λ 410 nm) |
|---|---|---|
| 5th layer (uppermost layer) | SiO₂ | 0.315 |
| 4th layer | Nb₂O₅ | 0.738 |
| 3rd layer | SiO₂ | 0.841 |
| 2nd layer | Nb₂O₅ | 0.777 |
| 1st layer (lowermost layer) | SiO₂ | 0.885 |

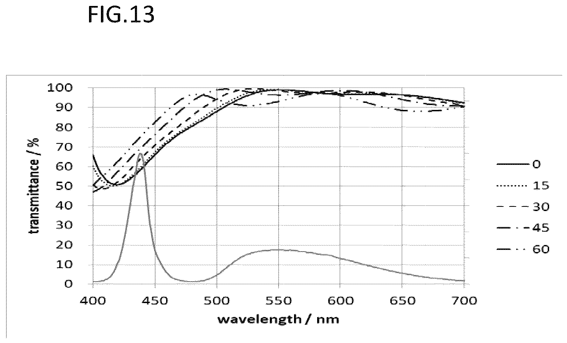

Fig. 13 shows a transmission spectrum of the multilayer film when an incident angle of light is changed in 15 degree increments. Similarly to the multilayer film of Example 1, the multilayer film of Example 2 also satisfies Conditions 1 to 3 in the present invention, and it is confirmed that a change in chromaticity can be adjusted by increasing the transmittance of a blue component in a blue wavelength region and decreasing the transmittance of a long wavelength region as an angle becomes wider, and that a high transmittance is ensured at 550 nm.

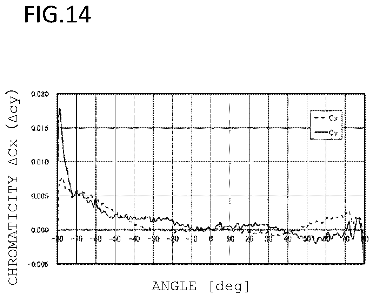

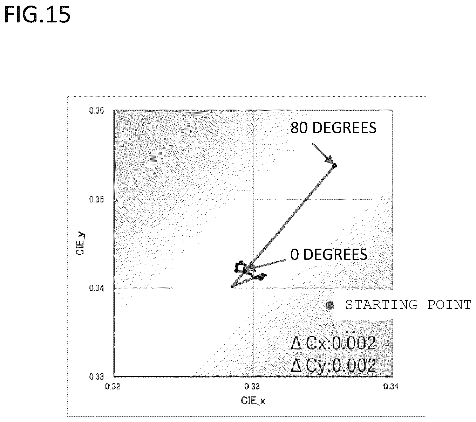

For the light-emitting device according to Example 2, Fig. 14 shows a variation (ΔCx, ΔCy) in chromaticity (Cx, Cy) depending on an angle which was measured by changing an emission angle from 0 degrees to 80 degrees, and Fig. 15 shows a change in chromaticity depending on an angle. As shown in Fig. 14, a difference in Cx value between an emission angle of 0 degrees and an incident angle of 80 degrees is 0.002, and a difference in Cy value is 0.002. As shown in Fig. 15, the values of chromaticity (Cx, Cy), which were measured at intervals of 5 degree of an emission angle, were (0.330, 0.342) at 0 degrees, (0.329, 0.343) at 20 degrees, (0.329, 0.342) at 40 degrees, (0.329, 0.342) at 45 degrees, (0.330, 0.341) at 55 degrees, (0.331, 0.341) at 60 degrees, (0.329, 0.340) at 75 degrees, and (0.336, 0.354) at 80 degrees. A difference in the Cx value and the Cy value was maximum between the emission angle of 75 degrees and the emission angle of 80 degrees. A difference between the Cx value at the emission angle of 75 degrees and the Cx value at the emission angle of 80 degrees was 0.007, and a difference in Cy value was 0.014.

Also in this example, it can be understood that both a change in the chromaticity Cx and a change in the chromaticity Cy can be suppressed to 0.02 or less over a wide angle range. Further, in the range of emission angles from 0 degrees to 60 degrees, a difference in Cx value was 0.002 (emission angles of 35 degrees and 60 degrees), and a difference in Cy value was 0.002 (emission angles of 20 degrees and 60 degrees), indicating that the difference in chromaticity could be extremely suppressed. Further, as shown in a chromaticity diagram in Fig. 15, a locus showing a change in chromaticity also has a folding part and a rotating part, and it can be understood that a change in chromaticity is small and the chromaticity remains in a white range (range of 0.30 to 0.40) over a wide angle range.

### <Comparative Example 1>

A light-emitting device of Comparative Example 1 was manufactured using the same LED package structure as in Example 1 by changing a configuration of a multilayer film to the following configuration.

### [Table 3]

**Table 3**

| | Composition | Optical film thickness (FWOT: λ 410 nm) |
|---|---|---|
| 5th layer (uppermost layer) | SiO₂ | 0.077 |
| 4th layer | Nb₂O₅ | 0.123 |
| 3rd layer | SiO₂ | 0.197 |
| 2nd layer | Nb₂O₅ | 0.123 |
| 1st layer (lowermost layer) | SiO₂ | 0.793 |

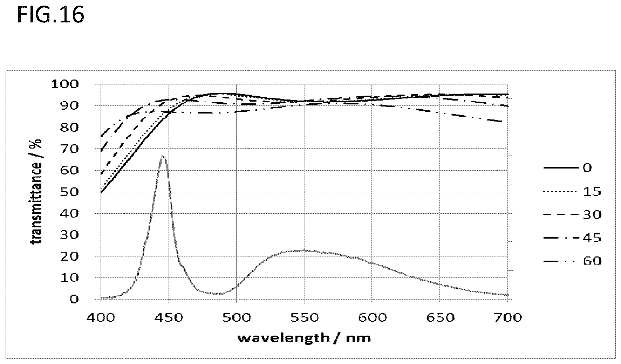

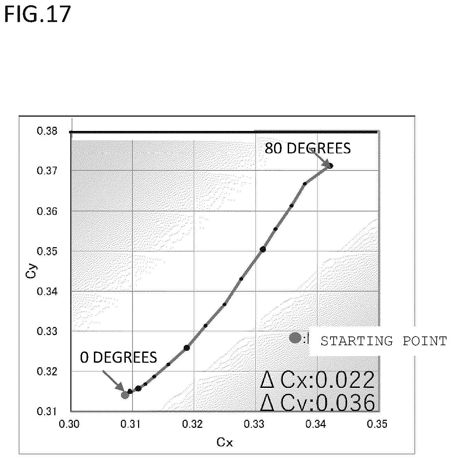

Fig. 16 shows a transmission spectrum of the multilayer film, and Fig. 17 shows changes in chromaticity. As can be understood from the transmission spectrum in Fig. 16, the multilayer film of Comparative Example 1 has a transmittance in a blue emission peak wavelength region, the transmittance increasing monotonically from 0 degrees to 45 degrees, but decreasing at 60 degrees. The multilayer film is not configured such that the transmittance gradually (monotonically) increases from an incident angle of 0 degrees to at least 60 degrees. In addition, as can be understood from the transmission spectrum in Fig. 16, in the multilayer film of Comparative Example 1, a transmittance in a blue wavelength region (450 nm) at an angle of 0 degrees exceeds 90%, making it difficult to adjust a variation in chromaticity depending on an angle in blue light. A locus in the change in chromaticity shown in Fig. 17 also shows a substantially linear change, and the change in chromaticity depending on an angle was large. A difference in Cx value between an emission angle of 0 degrees and an emission angle of 80 degrees was 0.022, and a difference in a Cy value was 0.036. A difference in Cx value between an emission angle of 15 degrees and an emission angle of 75 degrees was maximum. A difference in Cx value between an emission angle of 15 degrees and an emission angle of 75 degrees was 0.023. A difference in Cy value between an emission angle of 20 degrees and an emission angle of 80 degrees was maximum. A difference in Cx value between an emission angle of 20 degrees and an emission angle of 80 degrees was 0.045.

When the optical film thickness of the multilayer film is small in this manner, a transmission spectrum for each angle tends to shift toward a short wavelength side, making it difficult to adjust chromaticity in a blue region.

### <Comparative Example 2>

A multilayer film was designed with nine layers using the same film-forming materials as in Example 1, and transmission spectra (calculated values) were obtained when an incident angle was changed from 0 degrees to 60 degrees in 15 degree increments.

### [Table 4]

**Table 4**

| | Composition | Optical film thickness (FWOT: λ 410 nm) |
|---|---|---|
| 9th layer (uppermost layer) | SiO₂ | 0.353 |
| 8th layer | Nb₂O₅ | 0.699 |
| 7th layer | SiO₂ | 0.712 |
| 6th layer | Nb₂O₅ | 0.642 |
| 5th layer | SiO₂ | 0.712 |
| 4th layer | Nb₂O₅ | 0.699 |
| 3rd layer | SiO₂ | 0.737 |
| 2nd layer | Nb₂O₅ | 0.699 |
| 1st layer (lowermost layer) | SiO₂ | 0.353 |

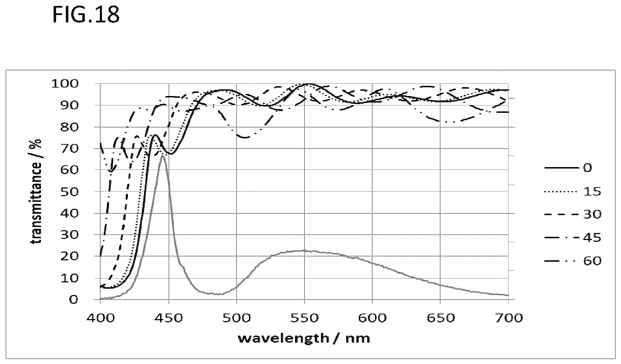

As shown in Fig. 18, in the transmission spectra of the multilayer film of Comparative Example 2, there is a steep change in transmittance in a blue wavelength region and a large change in transmittance depending on an angle (blue shift). Each of the spectra also shows a large waviness in a wavelength region of 450 nm or more. Thus, in the multilayer film of Comparative Example 2, it is not possible to eliminate a blue shift that occurs as an angle becomes wider, and it is difficult to adjust a change in chromaticity depending on the angle. From the results of Example 1 and Comparative Example 2, it can be understood that it is difficult to realize the light-emitting device of the present invention (a light-emitting device that satisfies Conditions 1 to 3) as the number of layers increases, and that a suitable number of layers is five.

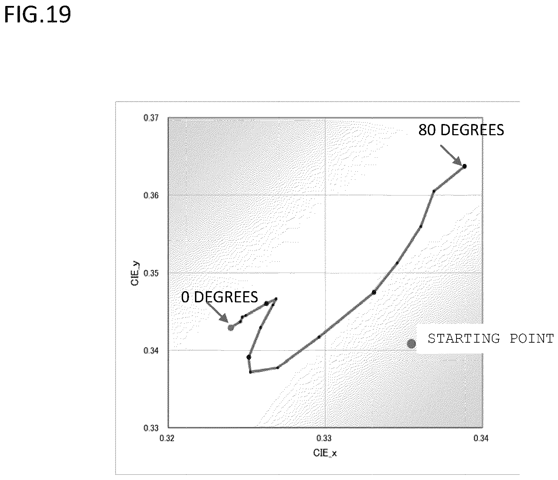

In addition, Fig. 19 shows changes in chromaticity of a light-emitting device when the multilayer film of Comparative Example 2 is used. In Comparative Example 2, a graph of a change in chromaticity has a turning point, but the change turns back significantly from a starting point (emission angle of 0 degrees) to a region where a Cy value is small, and it can be understood that the adjustment of the chromaticity is not sufficient. A difference in Cx value between an emission angle of 0 degrees and an emission angle of 80 degrees was 0.007, and a difference in Cy value was 0.014. A difference in the Cx value and the Cy value was maximum between an emission angle of 45 degrees and an emission angle of 75 degrees. A difference in Cx value between the emission angle of 45 degrees and the emission angle of 75 degrees was 0.011, and a difference in Cy value was 0.022.

From the results of the above-described examples, it is confirmed that, by performing control so that the transmittance of a blue region is increased as the angle becomes wider while maintaining the transmittance within an appropriate range, by performing control so that the transmittance of a long wavelength region is decreased as the angle becomes wider, and by maintaining the transmittance of a wavelength with high luminosity at 90% or more, a change in chromaticity depending on an emission angle and a blue shift are suppressed, and the amount of light emitted in the region with high luminosity is maintained.

### Reference Signs List

10: LED element
20: wavelength conversion part
25: wavelength conversion layer (wavelength conversion part)
30: optical multilayer film
40: glass plate
50: light-emitting element (not including multilayer film)
60: headlamp (vehicle lamp)
61: semiconductor light-emitting device
62: condensing reflector
63: projection lens
64: shade

## Claims

1. A semiconductor light-emitting device comprising:
a light-emitting element that includes an LED element and a wavelength conversion part that receives light emitted by the LED element and emits light having a wavelength different from that of the light emitted by the LED element, the light-emitting element emitting light which is a mixture of the light emitted by the LED element and the light emitted by the wavelength conversion part; and
an optical multilayer film that is disposed on a light-emitting surface of the light-emitting element, wherein
the optical multilayer film has a transmission spectrum in which, when an emission angle in a direction perpendicular to the light-emitting surface is 0 degrees and an emission angle in a direction parallel to the light-emitting surface is 90 degrees, a transmittance increases monotonically in a range of 0 degrees to at least 60 degrees at an emission peak wavelength of the LED element, a transmittance decreases monotonically in a range of 0 degrees to at least 60 degrees at a wavelength in a range of 650 nm to 700 nm, and a transmittance at 550 nm is 90% or more.

2. The semiconductor light-emitting device according to claim 1, wherein a transmittance at an angle of 0 degrees at the emission peak wavelength of the LED element is 50% or more and 70% or less, and a transmittance at an angle of 60 degrees is 85% or less.

3. The semiconductor light-emitting device according to claim 1 or 2, wherein chromaticity Cx and chromaticity Cy of the emitted light in the CIE 1931 chromaticity system are both in a range of 0.30 to 0.40.

4. The semiconductor light-emitting device according to any one of claims 1 to 3, wherein variations ΔCy and Δy in chromaticity of the emitted light in the CIE 1931 chromaticity system are both 0.03 or less.

5. The semiconductor light-emitting device according to any one of claims 1 to 4, wherein the optical multilayer film is a film in which low refractive index layers made of a low refractive index material and high refractive index layers made of a high refractive index material are alternately stacked, and the number of layers is nine or less.

6. The semiconductor light-emitting device according to claim 5, wherein a difference in refractive index between the high refractive index layer and the low refractive index layer is 0.6 to 1.0.

7. The semiconductor light-emitting device according to claim 5 or 6, wherein an optical film thickness of the high refractive index layer is 0.7 to 0.85 at a central wavelength λ of the optical multilayer film.

8. The semiconductor light-emitting device according to any one of claims 5 to 7, wherein an optical film thickness of the low refractive index layer (excluding an uppermost layer of the optical multilayer film) is 0.7 to 0.9 at the central wavelength λ of the optical multilayer film.

9. A vehicle lamp comprising the semiconductor light-emitting device according to any one of claims 1 to 8 as a light source.

## Amended claims

### Amended claims under Art. 19.1 PCT

1. A semiconductor light-emitting device comprising:
a light-emitting element that includes an LED element and a wavelength conversion part that receives light emitted by the LED element and emits light having a wavelength different from that of the light emitted by the LED element, the light-emitting element emitting light which is a mixture of the light emitted by the LED element and the light emitted by the wavelength conversion part; and
an optical multilayer film that is disposed on a light-emitting surface of the light-emitting element, wherein
the optical multilayer film has a transmission spectrum in which, when an emission angle in a direction perpendicular to the light-emitting surface is 0 degrees and an emission angle in a direction parallel to the light-emitting surface is 90 degrees, a transmittance increases monotonically in a range of 0 degrees to at least 60 degrees at an emission peak wavelength of the LED element, a transmittance decreases monotonically in a range of 0 degrees to at least 60 degrees at a wavelength in a range of 650 nm to 700 nm, and a transmittance at 550 nm is 90% or more in a range of 0 degrees to at least 60 degrees.

2. The semiconductor light-emitting device according to claim 1, wherein in the transmission spectrum of the optical multilayer film, a transmittance at an angle of 0 degrees at the emission peak wavelength of the LED element is 50% or more and 70% or less, and a transmittance at an angle of 60 degrees is 85% or less.

3. The semiconductor light-emitting device according to claim 1 or 2, wherein chromaticity Cx and chromaticity Cy of the emitted light in the CIE 1931 chromaticity system are both in a range of 0.30 to 0.40.

4. The semiconductor light-emitting device according to any one of claims 1 to 3, wherein variations ΔCy and Δy in chromaticity of the emitted light in the CIE 1931 chromaticity system are both 0.03 or less.

5. The semiconductor light-emitting device according to any one of claims 1 to 4, wherein the optical multilayer film is a film in which low refractive index layers made of a low refractive index material and high refractive index layers made of a high refractive index material are alternately stacked, and the number of layers is nine or less.

6. The semiconductor light-emitting device according to claim 5, wherein a difference in refractive index between the high refractive index layer and the low refractive index layer is 0.6 to 1.0.

7. The semiconductor light-emitting device according to claim 5 or 6, wherein an optical film thickness of the high refractive index layer is 0.7 to 0.85 at a central wavelength λ of the optical multilayer film.

8. The semiconductor light-emitting device according to any one of claims 5 to 7, wherein an optical film thickness of the low refractive index layer (excluding an uppermost layer of the optical multilayer film) is 0.7 to 0.9 at the central wavelength λ of the optical multilayer film.

9. A vehicle lamp comprising the semiconductor light-emitting device according to any one of claims 1 to 8 as a light source.
